# EUROPEAN PATENT APPLICATION

(11) **EP 4 834 859 A1**
(43) Date of publication of application: **04.11.2026**
(21) Application number: 24909602.5
(22) Date of filing: 19.06.2024
(51) Int. Cl.: C03C 17/34, C23C 14/08, H05K 5/03, B32B 33/00

(54) **GLASS PRODUCT AND ELECTRONIC DEVICE**

(30) Priority: 28.12.2023 CN 202323667790 U
(71) Applicant: BYD Company Limited, Shenzhen, Guangdong 518118 (CN)
(72) Inventor: LI, Yaoshan, Shenzhen, Guangdong 518118 (CN); MA, Lan, Shenzhen, Guangdong 518118 (CN); LIU, Yuyang, Shenzhen, Guangdong 518118 (CN); ZHANG, Yan, Shenzhen, Guangdong 518118 (CN)
(74) Representative: Taor, Simon Edward William
(86) International application number: PCT/CN2024/100067
(87) International publication number: WO 2025/138642

(57) **Abstract**

The present disclosure provides a glass product (200) and an electronic device. The glass product comprises a glass substrate (10), the glass substrate (10) has a first surface (101) and a second surface (102) which are arranged opposite to each other, a superhard film (20) is arranged on the first surface (101), and a brightness enhancement film (50) is arranged on the second surface (102), wherein the reflectivity of the brightness enhancement film (50) is greater than or equal to 25%, and the light transmittance of the superhard film (20) is greater than or equal to 50%.

## Description

This application claims priority to Chinese Patent Application No. 202323667790.2, filed with the China National Intellectual Property Administration on December 28, 2023 and entitled "GLASS ARTICLE AND ELECTRONIC DEVICE", which is incorporated herein by reference in its entirety.

### TECHNICAL FIELD

The present disclosure relates to the field of decorative glass technologies, and specifically to a glass article and an electronic device.

### BACKGROUND

Glass is a commonly used material for a rear cover of an electronic device such as a mobile phone. To enhance a decorative appearance of the rear cover, various decorative films are deposited on a glass substrate. Most common decoration is to manufacture a super-hard film on one side (usually an outer side) of the glass substrate, to improve decorative effect while increasing hardness and abrasion resistance of the rear cover. However, after the super-hard film is deposited on one side of the glass substrate, a strength of the deposited glass substrate decreases significantly compared with the glass substrate without a deposited film, and a percentage reduction is usually at least 30%, thereby affecting drop resistance of the electronic device. In addition, in an existing glass article with a super-hard film deposited on one outer surface, implementing high brightness requires a thick super-hard film, which increases manufacturing costs and results in poor color tunability of the glass article.

### SUMMARY

In view of this, the present disclosure provides a glass article and an electronic device. In the glass article, a super-hard film and a brightness enhancement film are disposed on two opposite sides of a glass substrate. With synergistic cooperation between the brightness enhancement film and the super-hard film, the glass article can ensure good abrasion resistance and a broad color-tuning range without a significant strength reduction.

Specifically, a first aspect of the present disclosure provides a glass article. The glass article includes a glass substrate, the glass substrate has a first surface and a second surface that are disposed opposite to each other, a super-hard film is disposed on the first surface, a brightness enhancement film is disposed on the second surface, a reflectivity of the brightness enhancement film is greater than or equal to 25%, and light transmittance of the super-hard film is greater than or equal to 50%.

In an embodiment of the present disclosure, a thickness d₁ of the brightness enhancement film and a thickness d₂ of the super-hard film satisfy the following relationship: 0.4 d₂≤d₁<d₂.

In this embodiment of the present disclosure, the thickness of the super-hard film is greater than or equal to 600 nm.

In this embodiment of the present disclosure, pencil hardness of the brightness enhancement film is at least 5H.

In this embodiment of the present disclosure, pencil hardness of the super-hard film is 9H, and Mohs hardness of the super-hard film is at least 7.

In this embodiment of the present disclosure, the brightness enhancement film includes a laminated structure formed by alternately stacking a first high-refractive-index material layer and a first low-refractive-index material layer, a refractive index of the first high-refractive-index material layer is greater than or equal to 2.0, and a refractive index of the first low-refractive-index material layer is less than or equal to 1.55.

In this embodiment of the present disclosure, the first high-refractive-index material layer includes one of a niobium pentoxide layer, a titanium dioxide layer, a trititanium pentoxide layer, a niobium nitride layer, or a titanium boride layer; and the first low-refractive-index material layer includes one of a silicon dioxide layer, an aluminum oxide layer, or a magnesium fluoride layer.

In this embodiment of the present disclosure, the first high-refractive-index material layer is the niobium pentoxide layer, and the first low-refractive-index material layer is the silicon dioxide layer.

In this embodiment of the present disclosure, the brightness enhancement film further includes one indium layer, and the indium layer is located between any adjacent first high-refractive-index material layer and first low-refractive-index material layer.

In this embodiment of the present disclosure, the super-hard film includes a laminated structure formed by alternately stacking a first super-hard high-refractive-index material layer and a second low-refractive-index material layer, a refractive index of the first super-hard high-refractive-index material layer is greater than or equal to 1.65, and a refractive index of the second low-refractive-index material layer is less than or equal to 1.55.

In this embodiment of the present disclosure, the first super-hard high-refractive-index material layer includes one of a silicon nitride layer, a zirconium dioxide layer, an aluminum nitride layer, a silicon oxynitride layer, or an aluminum oxynitride layer; and the second low-refractive-index material layer includes a silicon dioxide layer or an aluminum oxide layer.

In this embodiment of the present disclosure, the first super-hard high-refractive-index material layer is the silicon nitride layer, and the second low-refractive-index material layer is the silicon dioxide layer.

In this embodiment of the present disclosure, an anti-fingerprint layer is further disposed on one side that is of the super-hard film and that is away from the glass substrate; and an ink layer is further disposed on one side that is of the brightness enhancement film and that is away from the glass substrate.

In this embodiment of the present disclosure, the glass article further includes a support film, and the support film is located between the brightness enhancement film and the ink layer, or between the glass substrate and the brightness enhancement film.

In an embodiment of the present disclosure, based on a four-point bending test method, compared with a measured bending strength of the glass substrate, a percentage reduction in a measured bending strength of the glass article is less than 20%.

In an embodiment of the present disclosure, based on a four-point bending test method, compared with a measured bending strength of the glass substrate, a percentage reduction in a measured bending strength of the glass article is less than 15%.

In an embodiment of the present disclosure, a bending strength of the glass article is at least 510 MPa.

In this embodiment of the present disclosure, a simulated prototype formed by combining the glass article with a 200 g counterweight is placed in a vibration abrasion tester filled with abrasive particles, at least half of the simulated prototype is kept buried in the abrasive particles, an abrasion resistance test is performed for at least 120 min at a vibration frequency of 5050±0.5 Hz, and a surface of the glass article exhibits no obvious abrasion and impact damage.

In this embodiment of the present disclosure, a thickness of the glass article is 0.05-0.2 mm, and a bending radius of the glass article is less than or equal to 5 mm.

In this embodiment of the present disclosure, the glass article does not fracture when a bending load applied to the glass article is greater than or equal to 300 N based on the four-point bending test method.

The super-hard film is disposed on one side of the glass substrate and the brightness enhancement film is disposed on another side. Cooperation between the two films can reduce impact of stress of the single-sided super-hard film on a glass strength, prevent a significant reduction in the glass strength after deposition, improve impact resistance of the glass, and ensure good abrasion resistance of the glass. In addition, introduction of the high-reflectivity brightness enhancement film can increase brightness of the glass article, significantly reduce the thickness of the super-hard film, reduce manufacturing costs of the super-hard film, and broaden a color-tuning range of the glass article. This glass article is particularly suitable for use as a rear cover of an electronic device.

A second aspect of the present disclosure provides an electronic device. The electronic device includes a housing assembled on an outer side of the electronic device, and a circuit board located inside the housing, where the housing includes the glass article according to the first aspect of the present disclosure. Specifically, the housing using this glass article may be a rear cover of the electronic device or a camera protective cover plate.

In this embodiment of the present disclosure, the housing includes the rear cover assembled on a rear side of the electronic device, and the rear cover uses the glass article.

In this embodiment of the present disclosure, the electronic device further includes a camera component located inside the housing, the housing includes a camera protective cover plate, the camera protective cover plate is disposed over the camera component, and the camera protective cover plate uses the glass article.

The housing of the electronic device includes the glass article, which has good abrasion resistance, good drop resistance, and color-tunable appearance. The electronic device includes, but is not limited to, a mobile phone, a tablet computer, a notebook computer, a smartwatch, or the like.

### BRIEF DESCRIPTION OF DRAWINGS

FIG. 1 is a diagram of a structure of a glass article commonly used for a rear cover of a mobile phone;
FIG. 2 is a diagram of a structure of a glass article according to an embodiment of the present disclosure;
FIG. 3 is a diagram of a structure of a glass article according to another embodiment of the present disclosure;
FIG. 4 is a diagram of a structure of a glass article according to still another embodiment of the present disclosure;
FIG. 5 is a diagram of a structure of a glass article according to another embodiment of the present disclosure;
FIG. 6A is a diagram of a three-dimensional structure of an electronic device according to an embodiment of the present disclosure;
FIG. 6B is a diagram of a rear structure of the electronic device in FIG. 6A;
FIG. 7 is a diagram of testing a glass strength based on a four-point bending test method;
FIG. 8A shows a reflectance curve of a glass article in Comparative Embodiment 2; and
FIG. 8B shows a reflectance curve of a glass article in Embodiment 1 of the present disclosure.

### DESCRIPTION OF EMBODIMENTS

The following describes embodiments of the present disclosure with reference to accompanying drawings in embodiments of the present disclosure.

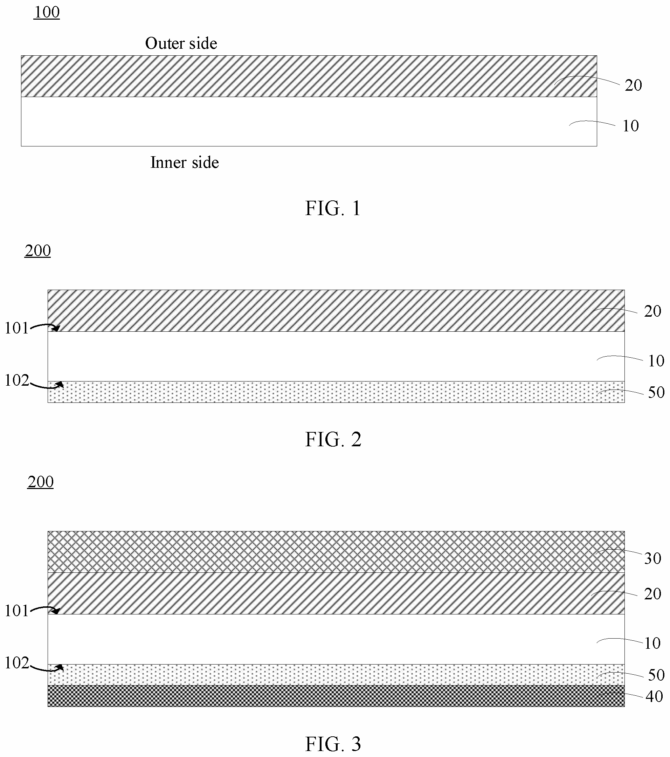

Currently, a rear cover of an electronic device such as a mobile phone usually uses a glass article with a single-sided super-hard film. A structure of the glass article is shown in FIG. 1. The glass article 100 includes a glass substrate 10, and a super-hard film 20 is disposed on one side of the glass substrate 10 (specifically, an outer side facing the outside of the electronic device). The glass article 100 has a high-hardness film layer only on one side and lacks a high-hardness film layer on another side for balance. Therefore, a strength of the glass article 100 is significantly reduced compared with that of the glass substrate 10. A percentage reduction in the strength is more than 30%, severely reducing impact resistance of the glass article 100 (for example, resulting in poor drop resistance). In addition, to achieve high brightness of the glass article 100, the super-hard film 20 is usually thick, at least 1 µm. This results in high manufacturing costs, and an excessively thick high-brightness super-hard film 20 provides only a narrow range of color decoration, thereby leading to poor color tunability of the glass article 100. To address the foregoing problems of the existing glass article, an embodiment of the present disclosure provides a glass article that implements good abrasion resistance, a high strength, a reduced thickness, and a broad color-tuning range.

FIG. 2 is a diagram of a structure of a glass article according to an embodiment of the present disclosure. The glass article 200 provided in this embodiment of the present disclosure includes a glass substrate 10. The glass substrate 10 has a first surface 101 and a second surface 102 that are disposed opposite to each other, a super-hard film 20 is disposed on the first surface 101, a brightness enhancement film 50 is disposed on the second surface 102, a reflectivity of the brightness enhancement film 50 is greater than or equal to 25%, and light transmittance of the super-hard film 20 is greater than or equal to 50%. Clearly, the brightness enhancement film 50 and the super-hard film 20 have different functions. In addition to higher hardness, the super-hard film 20 has higher light transmittance, while the brightness enhancement film 50 has higher a reflectivity and poorer light transmittance.

When the glass article 200 is used as a housing of an electronic device, such as a rear cover, the first surface 101 faces the outside of the electronic device ("outside" specifically means a part that a user can directly touch or see), and the second surface 102 faces the inside of the electronic device. Therefore, the first surface 101 may be referred to as an "outer surface" and the second surface 102 may be referred to as an "inner surface". Correspondingly, the super-hard film 20 faces the outside of the electronic device, and the brightness enhancement film 50 faces the inside of the electronic device.

In the present disclosure, the super-hard film 20 is disposed on the outer surface of the glass substrate 10 and the brightness enhancement film 50 is disposed on the inner surface. With cooperation between the brightness enhancement films 50 and the brightness enhancement film 50 on two sides of the glass substrate, while ensuring high abrasion resistance, the glass article 200 can reduce impact of stress of the single-sided super-hard film on a glass strength, and "balance" stress on the two sides of the glass substrate, thereby allowing a high strength of the glass article 200 and ensuring good impact resistance. In addition, introduction of the high reflectivity brightness enhancement film 50 can significantly increase brightness of the glass article 200. Specifically, when light enters from an outer side of the glass article 200, after light passes through the high light transmittance super-hard film 20 and the glass substrate 10, and is reflected by the high reflectivity brightness enhancement film 50, more light passes through the glass substrate 10 and the super-hard film 20 and enter human eyes, and the glass article 200 has high brightness to the human eyes. When the glass article 200 in this embodiment of the present disclosure achieves the same brightness as the existing glass article 100, a thickness of the super-hard film 20 in the glass article 200 in this embodiment of the present disclosure is significantly lower than the thickness of the super-hard film 20 in the existing glass article 100. In this way, manufacturing costs of the super-hard film 20 in the glass article 200 in this embodiment of the present disclosure are reduced, and the thinner super-hard film 20 is less prone to warping, increasing stability of a film layer. In addition, with the reduced thickness of the super-hard film 20, a reflectance curve of the glass article becomes smoother in a film stack design, resulting in improved color stability. This facilitates color tuning of the glass article 200 and broadens a color-tuning range of the glass article 200. In addition, the reduced thickness of the super-hard film 20 further facilitates an appropriate reduction in an overall thickness of the glass article 200 compared with the glass article 100, thereby facilitating manufacturing of a thinner and lighter housing of the electronic device.

Therefore, the glass article 200 provided in this embodiment of the present disclosure has many advantages such as high hardness (which may be reflected by good abrasion resistance), a high strength, a low thickness, and broad color tunability. This glass article 200 is suitable for manufacturing an electronic device with good mechanical performance and high aesthetics.

In the present disclosure, the reflectivity of the brightness enhancement film 50 is controlled to be greater than or equal to 25%, to ensure brightness enhancement effect of the brightness enhancement film 50 on a color and avoid weakening the brightness enhancement effect due to low reflectivity of the brightness enhancement film 50. In addition, the light transmittance (specifically visible-light transmittance) of the super-hard film 20 is controlled to be greater than or equal to 50%, to ensure that a light loss in a process in which light passes through the super-hard film 20 is not excessively low, thereby avoiding a reduction in the brightness enhancement effect of the light reflected from the brightness enhancement film 50 after passing through the super-hard film 20. In some implementations of the present disclosure, the reflectivity of the brightness enhancement film 50 being at least 30% may further be at least 40%, 50%, 60%, 70%, or the like. Visible light transmittance of the super-hard film 20 is at least 55%, 60%, 70%, 80%, 90%, or the like. In addition, the visible light transmittance of the brightness enhancement film 50 is less than 50%.

In this implementation of the present disclosure, pencil hardness of the brightness enhancement film 50 is at least 5H. Due to high hardness of the brightness enhancement film 50, when the brightness enhancement film 50 is disposed on another side of the glass substrate that is opposite to the super-hard film 20, the impact of the stress of the single-sided super-hard film on the glass strength can be effectively offset. The term "pencil hardness" means a type of scratch hardness measured according to a pencil hardness test method for a coating film.

In the present disclosure, under a same hardness comparison standard, hardness of the super-hard film 20 is greater than that of the brightness enhancement film 50. In this implementation of the present disclosure, pencil hardness of the super-hard film 20 may be 9H, and Mohs hardness of the super-hard film 20 may be at least 7. The super-hard film 20 located on the outer side of the glass substrate has high hardness, which helps ensure excellent abrasion resistance of the glass article 200. The term "Mohs hardness", also referred to as scratch hardness, is a type of relative hardness. Mohs hardness uses 10 natural minerals as reference standards. A hardness rank does not indicate a hardness value of an object to be tested, but only shows that a mineral with a higher hardness rank can scratch a mineral with a lower hardness rank. Hardness of another material is determined by comparing scratchability with that of the standard minerals through mutual scratching. In the present disclosure, the Mohs hardness is measured using a pyramidal diamond stylus of known hardness to scratch a surface of the object to be tested according to a scratch method.

In this implementation of the present disclosure, based on a four-point bending test method, compared with a measured bending strength of the glass substrate 10 without the brightness enhancement film 50 and the super-hard film 20, a percentage reduction in a measured bending strength of the glass article 100 is less than 20%. For example, if the bending strength of the glass article 100 is denoted as a MPa, the bending strength of the uncoated glass substrate 10 is denoted as b MPa, and the percentage reduction is denoted as k, and k=(b-a)/b×100%. In some implementations, the percentage reduction is less than 15%, and may further be less than 12%, 11%, or 10%.

In this implementation of the present disclosure, the measured bending strength of the glass article 100 based on the four-point bending test method may be at least 490 MPa, and may further be at least 510 MPa, 530 MPa, 535 MPa, 540 MPa, or the like.

In this implementation of the present disclosure, the glass article does not fracture when a bending load applied to the glass article is greater than or equal to 300 N based on the four-point bending test method. This indicates that the glass article has a high mechanical strength.

In some implementations of the present disclosure, a thickness d₁ of the brightness enhancement film 50 and a thickness d₂ of the super-hard film 20 satisfy the following relationship: 0.4 d₂≤d₁<d₂. d₁ and d₂ are measured in a same unit. Disposing the brightness enhancement film 50 whose thickness satisfies the relationship on the another side of the glass substrate that is opposite to the super-hard film 20 can effectively offset the impact of the stress of the single-sided super-hard film on the glass strength. In this case, based on the four-point bending test method, compared with the measured bending strength of the glass substrate 10, the percentage reduction in the measured bending strength of the glass article 100 is less than 15%. The bending strength of glass article 100 may be at least 510 MPa, and may further be at least 530 MPa. In some implementations, d₁/d₂ may fall within a range of 0.5-0.95, for example, specifically 0.55, 0.60, 0.65, 0.68, 0.70, 0.72, 0.75, 0.80, or 0.90.

In this implementation of the present disclosure, to ensure high hardness and good abrasion resistance of the super-hard film 20, the thickness d₂ of the super-hard film 20 may be greater than or equal to 600 nm. In some implementations, the thickness d₂ of the super-hard film 20 may fall within a range of 600-950 nm. A super-hard film 20 of an appropriate thickness ensures high hardness and a stable film layer structure of the glass article 200. In cooperation with the brightness enhancement film 50, the super-hard film 20 can increase brightness of the glass article 200, and broaden a color-tuning range of the glass article 200. For example, d₂ may be specifically 620 nm, 640 nm, 660 nm, 680 nm, 700 nm, 720 nm, 750 nm, 800 nm, 820 nm, 850 nm, 900 nm, or 950 nm. In some embodiments, d₂ may fall within a range of 600-900 nm, and may further be in a range of 600-860 nm.

In some implementations of the present disclosure, the thickness d₁ of the brightness enhancement film 50 falls within a range of 240-600 nm. A brightness enhancement film 50 of an appropriate thickness can better offset the stress generated by the super-hard film deposited on one outer surface while ensuring the brightness of the glass article 100, thereby enhancing the strength of the glass article.

In this implementation of the present disclosure, the brightness enhancement film 50 includes a laminated structure formed by alternately stacking a first high-refractive-index material layer and a first low-refractive-index material layer. In other words, the brightness enhancement film 50 includes at least one first high-refractive-index material layer (briefly referred to as a layer A) and at least one first low-refractive-index material layer (briefly referred to as a layer B), and the layer A and the layer B are alternately stacked. It may be understood that, a refractive index of the layer A is greater than that of the layer B. In a direction from the glass substrate 10 to the brightness enhancement film 50, the stacked structure of the brightness enhancement film 50 may be arranged in a form of (A-B)ₙ, (B-A)ₙ, (A-B)ₙ-A, or (B-A)ₙ-B (n is an integer greater than or equal to 1). Thicknesses of all layers A may be the same or different. Thicknesses of all layers B may be the same or different.

In this implementation of the present disclosure, the refractive index of the layer A may be greater than or equal to 2.0, and the refractive index of the layer B may be less than or equal to 1.55. The layer A may include one of a niobium pentoxide layer (namely, an Nb₂O₅ layer), a titanium dioxide layer (namely, a TiO₂ layer), a trititanium pentoxide layer (namely, a Ti₃O₅ layer), a niobium nitride layer (such as an NbN layer), or a titanium boride layer (such as a TiB layer). The layer B may include one of a silicon dioxide layer (namely, a SiO₂ layer), an aluminum oxide layer (namely, an Al₂O₃ layer), or a magnesium fluoride layer (namely, a MgF₂ layer).

In some embodiments of the present disclosure, the layer A is the niobium pentoxide layer, and the layer B is the silicon dioxide layer. A high-refractive-index material of the brightness enhancement film 50 is Nb₂O₅, which has a high refractive index of generally approximately 2.3. The refractive index is not prone to change, performance is stable, and an absorption coefficient is small, helping ensure that the brightness enhancement film 50 meets an optical design requirement. A low-refractive-index material of the brightness enhancement film 50 is SiO₂, which has a low refractive index of approximately 1.45 and low manufacturing costs.

In some implementations of the present disclosure, the brightness enhancement film 50 further includes one indium layer (namely, an In layer), and presence of the indium layer can enhance reflection effect of the brightness enhancement film 50. The indium layer is located between any adjacent first high-refractive-index material layer (a layer A) and first low-refractive-index material layer (a layer B). For example, in some embodiments, the brightness enhancement film 50 includes two layers A and two layers B, the layers A and the layers B are alternately stacked, and a layer A is in contact with the glass substrate 10. In this case, in a direction from the glass substrate 10 to the brightness enhancement film 50, the indium layer may be located between a first layer A and a first layer B, or between the first layer B and a second layer A, or between the second layer A and a second layer B. If the indium layer is denoted as a layer C, in the direction from the glass substrate 10 to the brightness enhancement film 50, the brightness enhancement film 50 may be specifically arranged in a form of A-C-B-A-B, A-B-C-A-B, or A-B-A-C-B.

In this implementation of the present disclosure, the super-hard film 20 includes a laminated structure formed by alternately stacking a first super-hard high-refractive-index material layer (briefly referred to as a layer D) and a second low-refractive-index material layer (briefly referred to as a layer E). It may be understood that, a refractive index of the layer D is greater than that of the layer E. In other words, the super-hard film 20 includes at least one D layer and at least one E layer, the D layer and E layer are alternately stacked, and the refractive index of the D layer is greater than that of the E layer. In a direction from the glass substrate 10 to the super-hard film 20, the stacked structure of the super-hard film 20 may be arranged in a form of (D-E)ₙ, (E-D)ₙ, (D-E)ₙ-D, or (E-D)ₙ-E (n is an integer greater than or equal to 1). Thicknesses of all layers D may be the same or different. Thicknesses of all layers E may be the same or different.

In this implementation of the present disclosure, the refractive index of layer D may be greater than or equal to 1.65, and the refractive index of layer E may be less than or equal to 1.55. The layer E may include one of a silicon dioxide layer (namely, a SiO₂ layer), or an aluminum oxide layer (namely, an Al₂O₃ layer). The D layer may include one of the following: a silicon nitride layer (a SiNₓ layer), a zirconium dioxide layer (namely, a ZrO₂ layer), an aluminum nitride layer (an AlNₓ layer), a silicon oxynitride layer (namely, a SiON layer), or an aluminum oxynitride layer (namely, an AlON layer). Refractive indexes of the silicon oxynitride layer and aluminum oxynitride layer may be greater than or equal to 1.65. Refractive index of the silicon nitride layer, the zirconium dioxide layer, and the aluminum nitride layer may be greater than or equal to 1.85.

In some embodiments of the present disclosure, the D layer is the silicon nitride layer and the E layer is the silicon dioxide layer. A high-refractive-index super-hard material of the super-hard film 20 is silicon nitride (with a refractive index of generally approximately 1.95), which has high hardness, excellent abrasion resistance performance, and stable chemical performance, thereby effectively enhancing hardness and abrasion resistance of the super-hard film 20. A low-refractive-index material of the brightness enhancement film 50 is SiO₂, which has a low refractive index of approximately 1.45 and low manufacturing costs.

The layer A, the layer B, the layer D, and the layer E may all be independently deposited through chemical vapor deposition, physical vapor deposition, or the like. Chemical vapor deposition includes, but is not limited to, hot wire chemical vapor deposition, plasma-enhanced chemical vapor deposition, or the like. Physical vapor deposition includes, but is not limited to, magnetron sputtering, vacuum evaporation, and ion plating (such as arc ion plating or radiofrequency ion plating). In some implementations of the present disclosure, the layer A, the layer B, the layer D, and the layer E are all deposited through magnetron sputtering. An example of a deposition process is as follows: Reactive gas for film layer formation and sputtering protective gas are introduced into a vacuum deposition chamber and ionized. Under an action of a strong magnetic field, the ionized gas bombards a surface of a sputtering target material, thereby forming a corresponding film layer on a substrate to be coated. In addition, during magnetron sputtering, ICP (Inductively Coupled Plasma, inductively coupled plasma) may be used to assist deposition, to improve adhesion of the film layer. A thickness, performance, and the like of the film layer can be controlled by adjusting parameters such as pressure in the deposition chamber, a temperature of the substrate to be coated, a rate of magnetron sputtering, power of the target material, flow rates of reactive gas and sputtering gas, ICP power, and the like.

In this implementation of the present disclosure, a thickness of the glass substrate 10 may fall within a range of 0.4-1.0 mm, for example, specifically 0.5 mm, 0.6 mm, 0.7 mm, 0.8 mm, or 0.9 mm. The glass substrate 10 is a base plate of the glass article 200, and plays a supporting role for the super-hard film 20, the brightness enhancement film 50, and the like. The glass substrate 10 may be silicate glass, borate glass, phosphate glass, or the like. In addition, these glass substrates may be specifically a chemically strengthened glass substrate, to provide protective effect when used as the housing of the electronic device.

In some implementations of the present disclosure, as shown in FIG. 3, an anti-fingerprint (Anti-finger, AF for short) layer 30 is further disposed on one side that is of a super-hard film 20 and that is away from a glass substrate 10. That is, the super-hard film 20 and an anti-fingerprint layer 30 are sequentially stacked on a first surface 101. The anti-fingerprint layer 30 is mainly used to reduce formation of fingerprints on a glass article 200 when a user touches the glass article 200, thereby preventing impact on appearance effect of the glass article 200. A thickness of the anti-fingerprint layer 30 may fall within a range of 5-30 nm.

In some implementations of the present disclosure, as shown in FIG. 3, an ink layer 40 is further disposed on one side that is of a brightness enhancement film 50 and that is away from the glass substrate 10. The ink layer 40 mainly serves a masking function, for example, masking a wiring structure subsequently disposed on an inner side of the glass article 200, thereby enhancing visual effect of the glass article 200. The ink layer 40 may be disposed through screen printing, inkjet printing, or the like. The ink layer 40 may be a complete film layer or a film layer arranged in an array. In addition, a color of the ink layer 40 may include, but is not limited to, red, orange, yellow, green, cyan, blue, purple, black, or the like. Any different color may be selected to meet different use requirements. In some specific embodiments, the color of the ink layer 40 is black. A position, a thickness, and the color of the ink layer 40 may be adjusted based on desired visual effect of the glass article 200. For example, the thickness of the ink layer 40 may fall within a range of 10-50 µm.

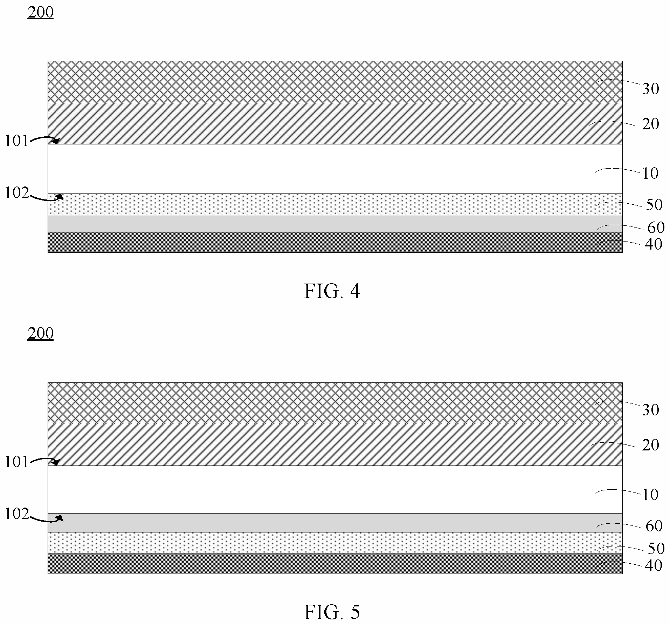

FIG. 4 is a diagram of a structure of a glass article according to still another embodiment of the present disclosure. A difference between the glass article shown in FIG. 4 and the glass article shown in FIG. 3 lies in that the glass article 200 in FIG. 4 further includes a support film 60. The support film 60 is located between a brightness enhancement film 50 and an ink layer 40.

Specifically, the support film 60 may be used to support the ink layer 40. For example, the ink layer 40 may be formed on one side of the support film 60, and then another side of the support film 60 may be attached to a glass substrate 10 which has a super-hard film 20 and the brightness enhancement film 50 on two opposite surfaces. In this implementation of the present disclosure, a material of the support film 60 may include polyethylene terephthalate (polyethylene terephthalate, PET), polyimide (polyimide, PI), and the like. In addition, to facilitate stable attachment between the support film 60 and the glass substrate 10 which has the super-hard film 20 and the brightness enhancement film 50 on the two opposite surfaces, a surface of the support film 60 may be provided with an adhesive layer, such as OCA (Optically Clear Adhesive) optically adhesive or pressure-sensitive adhesive. The thickness of the support film 60 may fall within a range of 0.1-0.5 mm.

In the glass article 200 shown in FIG. 4, the super-hard film 20 and the brightness enhancement film 50 are disposed on two opposite sides of the glass substrate 10, which can achieve similar effect of the glass article shown in FIG. 2. That is, with the super-hard film on an outer side and the brightness enhancement film on an inner side, the brightness enhancement film 50 can offset impact of stress of the single-sided super-hard film on a glass strength, so that it can be ensured that a strength of the glass article 200 does not exhibit a significant reduction compared with that of a glass substrate without a deposited film, and the thickness of the super-hard film may be reduced, thereby increasing a color-tuning range of the glass article 200. For the super-hard film 20, an anti-fingerprint layer 30, the brightness enhancement film 50, and the ink layer 40, refer to the foregoing descriptions in the present disclosure.

FIG. 5 is a diagram of a structure of a glass article according to still another embodiment of the present disclosure. A difference between the glass article shown in FIG. 5 and the glass article shown in FIG. 3 lies in that the glass article 200 in FIG. 5 further includes a support film 60. The support film 60 is located between a glass substrate 10 and a brightness enhancement film 50.

The support film 60 in FIG. 5 may be used to support the brightness enhancement film 50 and an ink layer 40. For example, the brightness enhancement film 50 may first be deposited on a first side of the support film 60, the ink layer 40 may be formed by printing, and then a second side (opposite to the first side) of the support film 60 may be attached to the glass substrate 10 with a super-hard film 20 on one side, so that the super-hard film 20 and the support film 60 are located on the two opposite sides of the glass substrate 10. Similarly, to facilitate stable attachment between the support film 60 and the glass substrate 10, a surface of the support film 60 may be provided with an adhesive layer, such as OCA adhesive or pressure-sensitive adhesive.

In the glass article 200 shown in FIG. 5, the super-hard film 20 and the brightness enhancement film 50 are disposed on the two opposite sides of the glass substrate 10, which can achieve similar effect of the glass article shown in FIG. 2. For the super-hard film 20, an anti-fingerprint layer 30, the brightness enhancement film 50, and the ink layer 40, refer to the foregoing descriptions in the present disclosure.

In the present disclosure, a simulated prototypes formed by combining each of the foregoing glass articles with a 200 g counterweight is placed in a vibration abrasion tester filled with abrasive particles, at least half of the simulated prototype is kept buried in the abrasive particles, an abrasion resistance test is performed for at least 120 min at a vibration frequency of 5050±0.5 Hz, and a surface of the glass article exhibits no obvious abrasion and impact damage. This indicates that the glass articles have good abrasion resistance and promising application prospects. In the process of preparing the simulated prototypes using the glass article, the 200 g counterweight is provided on one side of the brightness enhancement film.

In some implementations of the present disclosure, a thicknesses of each glass article 100 may fall within a range of 0.05-0.2 mm. In this case, a bending radius of the glass article can still be less than or equal to 5 mm. This indicates that the thinner glass article with the super-hard film 20 and the brightness enhancement film 50 can still exhibit good bending performance, making it suitable for use as ultra-thin flexible glass (UTG) in a foldable electronic device. Furthermore, film layers of the glass article exhibit no cracking, damage, delamination, or the like. Specifically, the thickness of the glass article 100 may be 0.06 mm, 0.08 mm, 0.1 mm, 0.12 mm, 0.15 mm, 0.2 mm, or the like. Further, in this case, the glass article does not fracture when a bending load applied to the glass article is greater than or equal to 300 N based on the four-point bending test method.

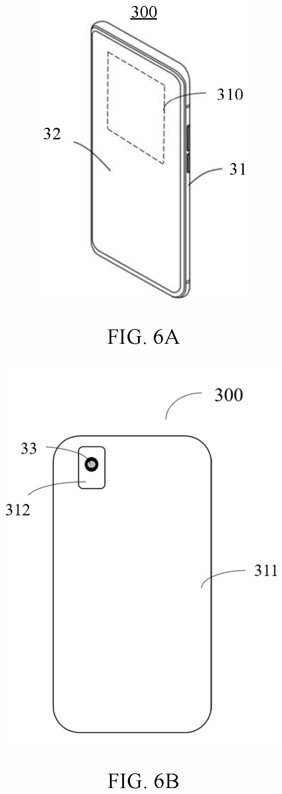

An embodiment of the present disclosure further provides an electronic device. A housing of the electronic device may include the glass articles described in embodiments of the present disclosure. Refer to both FIG. 6A and FIG. 6B. FIG. 6A is a diagram of a three-dimensional structure of an electronic device 300 according to an embodiment of the present disclosure. FIG. 6B is a diagram of a rear structure of the electronic device in FIG. 6A. The electronic device 300 may be a mobile phone, a tablet computer, a notebook computer, a wearable device (such as a smartwatch, or a smart band), an augmented reality (Augmented Reality, AR) device, a virtual reality (Virtual Reality, VR) device, a vehicle-mounted device, or the like. This is not limited in the present disclosure. In this embodiment, an example in which the electronic device 300 is a mobile phone is used for description.

The electronic device 300 may include a housing 31 assembled on an outer side of the electronic device, and a circuit board 310 located inside the housing 31. The electronic device 300 may further include a display assembly 32. The display assembly 32 is connected to the housing 31. Specifically, the display assembly 32 may be mounted on the housing 31. The housing 31 includes a rear cover 311 assembled on a rear side of the electronic device 300. The rear cover 311 may cover only the rear side of the electronic device 300 (namely, one side away from the display assembly 32), or may cover both the rear side and a side frame of the electronic device 300. In an implementation of the present disclosure, the rear cover 311 may be manufactured using the glass article 200 in an embodiment of the present disclosure. The rear cover 311 may be entirely manufactured using the glass article 200, or may be partially manufactured using the glass article 200. When the rear cover 311 is manufactured using the glass article 200, the ink layer 40 of the glass article 200 faces the display assembly 32, and the anti-fingerprint layer 30 is away from the display assembly 32. A processor is disposed on the circuit board 310, and the processor is used to control the display assembly 32 to display an image.

In some implementations of the present disclosure, as shown in FIG. 6B, the electronic device 300 further includes a camera component 33 located inside the housing 31. The housing may include a camera protective cover plate 312. The camera protective cover plate 312 is disposed over the camera component 33, to protect the camera component 33. The camera protective cover plate 312 may be manufactured using the glass article 200 in embodiments of the present disclosure. Specifically, the camera protective cover plate 312 may be entirely manufactured using the glass article 200, or may be partially manufactured using the glass article 200.

The rear cover 311 and/or camera protective cover plate 312 of the electronic device 300 may use the glass article 200 in embodiments of the present disclosure, thereby providing good abrasion resistance, a mechanical strength, and brilliant, color-tunable appearance, which enhances market competitiveness of the electronic device.

The following describes the technical solutions of the present disclosure in detail by using specific embodiments.

### Embodiment 1

A glass article with a structure shown in FIG. 2 includes a glass substrate 10 with a thickness of 0.55 mm. A super-hard film 20 with a total thickness d₂ of 640 nm is disposed on a first surface 101 of the glass substrate 10, and is specifically a six-layer film layer formed by alternately stacking silicon nitride layers and SiO₂ layers. There are three silicon nitride layers and three SiO₂ layers. A SiO₂ layer is directly attached to the glass substrate 10. A brightness enhancement film 50 with a total thickness d₁ of 440 nm is disposed on a second surface 102 of the glass substrate 10, and is specifically a four-layer film layer formed by alternately stacking Nb₂O₅ layers and SiO₂ layers. There are two Nb₂O₅ layers and two SiO₂ layers. An Nb₂O₅ layer is directly attached to the glass substrate 10.

In addition, in Embodiment 1, visible light transmittance of the super-hard film 20 is 62%, and a reflectivity of the brightness enhancement film 50 is 35%. d₁/d₂=0.68.

### Embodiment 2

A difference from the glass article in Embodiment 1 lies in that a ratio of a total thickness d₁ of a brightness enhancement film 50 to a thickness d₂ of a super-hard film 20 is 0.4. In a glass article in Embodiment 2, the total thickness d₂ of the super-hard film is 850 nm, and the total thickness d₁ of the brightness enhancement film 50 is 340 nm. A quantity of layers and film layer structures of the super-hard film and the brightness enhancement film 50 are the same as those in Embodiment 1.

### Embodiment 3

A difference from the glass article in Embodiment 1 lies in that a ratio of a total thickness d₁ of a brightness enhancement film 50 to a thickness d₂ of a super-hard film 20 is 0.9. In a glass article in Embodiment 3, the total thickness d₂ of the super-hard film is 600 nm, and a film layer structure is the same as that in Embodiment 1; and the total thickness d₁ of the brightness enhancement film 50 is 540 nm, and the brightness enhancement film 50 is specifically a 9-layer film layer formed by alternately stacking Nb2O5 layers and SiO₂ layers. There are four Nb2O5 layers and five SiO₂ layers, and a SiO₂ layer is directly attached to a glass substrate 10.

### Embodiment 4

A difference from the glass article in Embodiment 1 lies in that a ratio of a total thickness d₁ of a brightness enhancement film to a thickness d₂ of a super-hard film is specifically 0.29, which is less than 0.4. In a glass article in Embodiment 4, the total thickness d₁ of the brightness enhancement film 50 is 187 nm. The brightness enhancement film 50 is specifically a 7-layer film layer formed by alternately stacking Nb2O5 layers and SiO₂ layers. There are three Nb2O5 layers and four SiO₂ layers. A SiO₂ layer is directly attached to a glass substrate 10.

### Embodiment 5

A difference from the glass article in Embodiment 1 lies in that a brightness enhancement film 50 is specifically a 4-layer film layer formed by alternately stacking Ti₃O₅ layer and SiO₂ layer. There are two Ti₃O₅ layers and two SiO₂ layers, and a Ti₃O₅ layer is directly attached to a glass substrate 10. A total thickness d₁ of the brightness enhancement film 50 is 271 nm. d₁/d₂=0.42.

To highlight the beneficial effects of the present disclosure, the following comparative embodiments are provided.

### Comparative Embodiment 1

A glass article, specifically the glass substrate used in Embodiment 1, is not provided with any film layer on a surface.

### Comparative Embodiment 2

A glass article with a structure shown in FIG. 1 includes a glass substrate 10 (the same as in Embodiment 1). A super-hard film 20 with a total thickness of 1100 nm is disposed on one side of the glass substrate 10. The super-hard film 20 is specifically a 10-layer film layer formed by alternately stacking silicon nitride layers and SiO₂ layers. There are five silicon nitride layers and five SiO₂ layers. A SiO₂ layer is directly attached to the glass substrate 10. Visible light transmittance of this super-hard film is 53%.

To support the beneficial effects of the present disclosure, the following performance tests are performed on the glass articles of the foregoing embodiments and the comparative embodiments.

a. Hardness test: A pyramidal diamond stylus is used to scratch surfaces of the glass articles to be tested (specifically, the super-hard films of the glass articles in the embodiments and Comparative Embodiment 2), and depths of resulting scratches are measured. The depths of the scratches are Mohs hardness.

Results show that Mohs hardness of the super-hard films of the glass articles in the embodiments and Comparative Embodiment 2 all reaches 8, whereas Mohs hardness of the uncoated glass substrate (Comparative Embodiment 1) is only 5.

### b. Abrasion resistance test:

A test device is a vibration abrasion tester R180/530 TE 30 (a frequency of the device is 50±0.5 Hz; and an amplitude of the device is 1.65±0.1 mm). A 15-liter mixed abrasive is used, including 3 parts by volume of RKF 10K (yellow cylindrical abrasive particles) and 1 part by volume of RKK 15P (green conical abrasive particles).

Test sample preparation: The glass articles in the embodiments and comparative examples are fixed together with a 200 g counterweight (for the embodiments and Comparative Embodiment 2, the counterweight is provided on one side of the glass substrate that is opposite to the super-hard film) to form simulated prototypes. The simulated prototype is placed into the vibration abrasion tester for testing. A maximum of two simulated prototypes are placed in one vibration abrasion tester to avoid collision.

A test procedure is as follows: (1) 1 L of water is evenly poured into a vibration chamber of the vibration abrasion tester containing the abrasive, to keep the abrasive in a moist state; and then, 200 mL of detergent is evenly poured (the detergent is obtained by diluting a commercially available German Rösler vibration abrasion testing solution FC120 at a volume ratio of 1:50) as a lubricant; (2) the simulated prototypes are numbered and placed into the vibration chambers containing the mixed abrasive; each simulated prototype is inserted into the abrasive with a top end facing upward, ensuring that at least half of a body of the simulated prototype is buried in the abrasive particles; the vibration abrasion tester is started, and a start moment is taken as a zero time point; and after 30 min, the simulated prototype is taken out and cleaned, appearance of the simulated prototype is checked, and the simulated prototype is photographed for recording; and (3) approximately 500 mL of water is evenly added into the vibration chamber again to ensure that the abrasive remains continuously moist; and step (2) is repeated; and the simulated prototype is taken out for observation and photographed for recording at a 60^{th} min, a 90^{th} min, a 90^{th} min, and a 120^{th} min.

Results show that when 120 min (namely, two hours) elapses since the abrasion resistance test, major surfaces and edges of the glass articles of the embodiments and Comparative Embodiment 2 exhibit no obvious abrasion and impact damage, and there is no film layer delamination or exposure of an underlying substrate. This indicates that the super-hard film of the glass article has good abrasion resistance. In contrast, a surface of the glass article in Comparative Embodiment 1 shows severe scratch damage.

### c. Glass strength test:

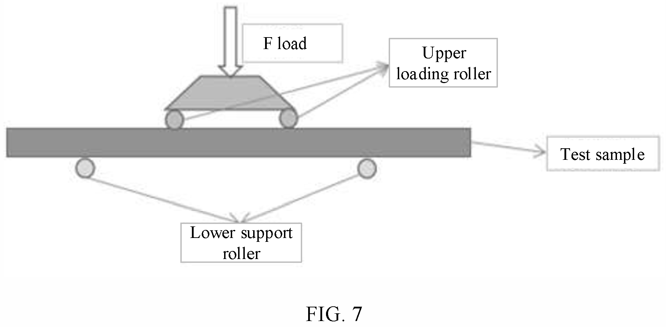

A glass strength is tested using a four-point bending test method, and a diagram is shown in FIG. 7. The test method includes the following steps.
① Process each glass article into a 3D curved surface sample; check appearance of each glass sample before testing, to ensure that the product is free of defects such as cracks, gaps or the like that affect the strength;
② Check and clean a support (located below a lower support roller) and an upper loading roller of a strength tester, to ensure that the upper and lower rollers are clean and free of serious surface scratches;
③ Fasten a test sample using a four-point bending test fixture, so that the test sample is located between the upper loading roller and the lower support roller, and located in the middle of two lower support rollers (as shown in FIG. 7), where a measurement direction of the test sample and selection of the upper and lower rollers are as follows: For a 3D curved surface product, measurement is performed in a Y-axis direction (a product length direction), and both the lower support roller and the upper loading roller have a diameter of 6 mm;
④ Set a preload, usually 1-2N, to ensure that the test sample is in contact with the upper and lower rollers;
⑤ Set a downward speed of the load to 10 mm/min;
⑥ Start a tester, begin to apply a bending load, and continuously apply a bending load at the downward speed of 10 mm/min until the test sample fractures; and record a maximum value of loads applied during the test, namely a maximum load F at a moment of fracture of the test sample;
⑦ Calculate the bending strength according to the following formula: $σ = 3 F \times \left(Ls-Lb\right) / \left(2B\times {H}^{2}\right) ,$ where
σ represents the bending strength of the test sample, in MPa;
F represents the maximum load corresponding to the moment of fracture of the test sample, in N;
Ls represents a distance between centerlines of the two lower support rollers, in mm; and Ls in the present disclosure is 40 mm;
Lb represents a distance between centerlines of two upper loading rollers, in mm; and Lb in the present disclosure is 20 mm;
B represents a width of the test sample (parallel to an extension direction of each roller), in mm; and
H represents a thickness of the test sample, in mm; and
⑧ Test five parallel samples for each group, and obtain an average value of five measured bending strengths. Test results are shown in Table 1.

**Table 1**

| Test item | Four-point bending test | |
|---|---|---|
| | Bending strength (MPa) | Average value (MPa) |
| Comparative Embodiment 1 | 604.107 | |
| | 606.306 | 616.25 |
| | 626.373 | |

| Test item | Four-point bending test | |
|---|---|---|
| | Bending strength (MPa) | Average value (MPa) |
| | 624.995 | |
| | 619.487 | |
| Comparative Embodiment 2 | 419.07 | 430.71 |
| | 428.19 | |
| | 454.9 | |
| | 421.09 | |
| | 430.31 | |
| Embodiment 1 | 545.46 | 564.00 |
| | 557.96 | |
| | 568.48 | |
| | 571.77 | |
| | 576.37 | |
| Embodiment 2 | 560.6 | 547.42 |
| | 551.23 | |
| | 537.16 | |
| | 556.97 | |
| | 531.13 | |
| Embodiment 3 | 590.6 | 580.42 |
| | 581.23 | |
| | 577.16 | |
| | 595.97 | |
| | 557.13 | |
| Embodiment 4 | 503.16 | 498.63 |
| | 511.5 | |
| | 521.32 | |
| | 461.77 | |
| | 495.42 | |

| Test item | Four-point bending test | |
|---|---|---|
| | Bending strength (MPa) | Average value (MPa) |
| | 585.14 | |
| | 553.12 | |
| Embodiment 5 | 549.47 | 556.56 |
| | 557.81 | |
| | 537.24 | |

It can be learned from Table 1 that, the bending strength of the glass article in Comparative Embodiment 2 in which the super-hard film is disposed on one side of the glass substrate decreases significantly compared with that of the glass substrate (Comparative Embodiment 1), by approximately 30.1%. In this embodiment of the present disclosure, after the super-hard film is disposed on one side of the glass substrate, and the brightness enhancement film is disposed on the opposite side, the bending strength of the resulting glass article is still high, and the bending strength decreases by less than 20% compared with the bending strength of the glass substrate. Specifically, the bending strengths of the glass articles in Embodiments 1-5 decrease by 8.48%, 11.17%, 5.81%, 19.09%, and 9.69% respectively compared with the bending strengths of the glass substrates. It can be learned from comparison between Embodiments 1-4 that, when the ratio of the thickness d₁ of the brightness enhancement film to the thickness d₂ of the super-hard film in the glass article is less than 0.4 (for example, the ratio is 0.29 in Embodiment 4), the glass article exhibits a higher percentage reduction in strength compared with the glass substrate.

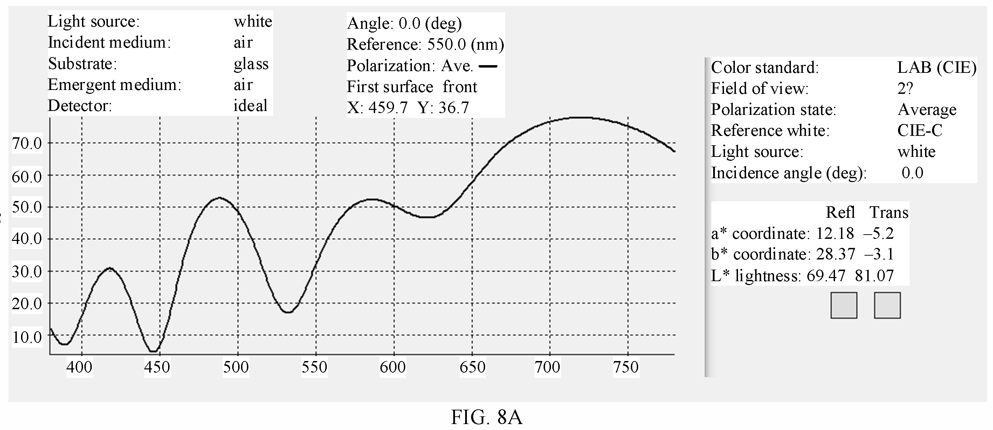

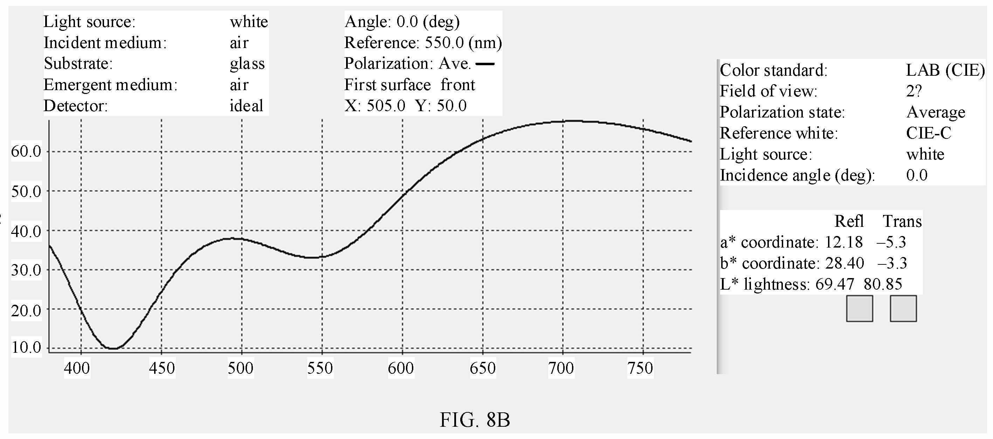

A reflectance test is further performed on the glass articles in Comparative Embodiment 2 and Embodiment 1. Specifically, white light is irradiated from the super-hard film side, an angle between an incident angle of the white light and a normal direction of the super-hard film is controlled to be 10°, and measured reflectance curves are shown in FIG. 8A and FIG. 8B respectively.

It can be learned from FIG. 8A and FIG. 8B that, the glass article in Comparative Embodiment 2 with the super-hard film on one side and the glass article in Embodiment 1 with the super-hard film on the outer side and the brightness enhancement film on the inner side may implement essentially same Lab chromaticity coordinates (in Lab chromaticity coordinates in Comparative Embodiment 2, a is 12.18, b is 28.37, and L is 69.47; and in Lab chromaticity coordinates in Embodiment 1, a is 12.18, b is 28.40, and L is 69.47); and the glass article in Embodiment 1 exhibits a smoother reflectance curve, indicating better color stability. It should be noted that when the two glass articles achieve similar color effect, in Comparative Embodiment 2, the thickness of the super-hard film is 1100 nm, while in Embodiment 1 in the present disclosure, the thickness of the super-hard film is only 640 nm, and the total thickness of the super-hard film and the brightness enhancement film is 1080 nm. It can be learned that to achieve same brightness/colors, the glass article in this embodiment of the present disclosure requires a much thinner super-hard film than the glass article in Comparative Embodiment with the super-hard film on one side, thereby facilitating color tuning.

In addition, the glass articles in Embodiments 2-5 also have essentially the same color effect as that in Embodiment 1, and reflectance curves are similar.

The results indicate that, in the glass article provided in embodiments of the present disclosure, the super-hard film is disposed on one side and the brightness enhancement film is disposed on the opposite side, the glass article exhibits good abrasion resistance and excellent mechanical performance without a significant reduction in strength. In addition, the thickness of the super-hard film of the glass article is small, facilitating tuning of appearance and color of the glass article.

The above are only example implementations of the present disclosure, and it should be noted that for a person of ordinary skill in the art, several improvements and modifications may be made without departing from the principle of the present disclosure, and these improvements and modifications are also regarded as falling within the protection scope of the present disclosure.

It should be noted that unless otherwise expressly specified and limited, terms "mount", "interconnect", and "connect" in the present disclosure should be understood in a broad sense. For example, such terms may indicate fastening, a detachable connection, or an integral connection; may indicate a mechanical connection; and may indicate direct interconnection, indirect interconnection through an intermediate or internal communications between two elements. For a person of ordinary skill in the art, a specific meaning of the foregoing terms in the present disclosure may be understood based on a specific situation.

The direction terms mentioned in the present disclosure, for example, "up", "down", "front", "back", "left", "right", "inside", "outside" and "side", are merely directions with reference to the accompanying drawings. Therefore, the orientation terms are used to better and more clearly describe and understand the present disclosure, instead of indicating or implying that an apparatus or element needs to have a specific orientation and be constructed and operated in a specific orientation, and cannot be understood as limitations on embodiments of the present disclosure.

In addition, in the descriptions of the present disclosure, unless otherwise specified, "a plurality of" means two or more. In addition, a value range represented by "-" means a range in which values before and after "-" are used as a minimum value and a maximum value respectively. In the accompanying drawings, units having similar or same structures are denoted by same reference numerals.

## Claims

1. A glass article (200), wherein the glass article (200) comprises a glass substrate (10), the glass substrate (10) has a first surface (101) and a second surface (102) that are disposed opposite to each other, a super-hard film (20) is disposed on the first surface (101), a brightness enhancement film (50) is disposed on the second surface (102), a reflectivity of the brightness enhancement film (50) is greater than or equal to 25%, and light transmittance of the super-hard film (20) is greater than or equal to 50%.

2. The glass article (200) according to claim 1, wherein a thickness d₁ of the brightness enhancement film (50) and a thickness d₂ of the super-hard film (20) satisfy the following relationship: 0.4 d₂≤d₁<d₂.

3. Glass article according to claim 1 or 2, wherein the thickness of the super-hard film (20) is greater than or equal to 600 nm.

4. The glass article (200) according to any one of claims 1 to 3, wherein pencil hardness of the brightness enhancement film (50) is at least 5H.

5. The glass article (200) according to any one of claims 1 to 4, wherein pencil hardness of the super-hard film (20) is 9H, and Mohs hardness of the super-hard film (20) is at least 7.

6. The glass article (200) according to any one of claims 1 to 5, wherein the brightness enhancement film (50) comprises a laminated structure formed by alternately stacking a first high-refractive-index material layer and a first low-refractive-index material layer, a refractive index of the first high-refractive-index material layer is greater than or equal to 2.0, and a refractive index of the first low-refractive-index material layer is less than or equal to 1.55.

7. The glass article (200) according to claim 6, wherein the first high-refractive-index material layer comprises one of a niobium pentoxide layer, a titanium dioxide layer, a trititanium pentoxide layer, a niobium nitride layer, or a titanium boride layer; and the first low-refractive-index material layer comprises one of a silicon dioxide layer, an aluminum oxide layer, or a magnesium fluoride layer.

8. The glass article (200) according to claim 7, wherein the first high-refractive-index material layer is the niobium pentoxide layer, and the first low-refractive-index material layer is the silicon dioxide layer.

9. The glass article (200) according to claim 6 or 7, wherein the brightness enhancement film (50) further comprises one indium layer, and the indium layer is located between any adjacent first high-refractive-index material layer and first low-refractive-index material layer.

10. The glass article (200) according to any one of claims 1 to 9, wherein the super-hard film (20) comprises a laminated structure formed by alternately stacking a first super-hard high-refractive-index material layer and a second low-refractive-index material layer, a refractive index of the first super-hard high-refractive-index material layer is greater than or equal to 1.65, and a refractive index of the second low-refractive-index material layer is less than or equal to 1.55.

11. The glass article (200) according to claim 10, wherein the first super-hard high-refractive-index material layer comprises one of a silicon nitride layer, a zirconium dioxide layer, an aluminum nitride layer, a silicon oxynitride layer, or an aluminum oxynitride layer; and the second low-refractive-index material layer comprises a silicon dioxide layer or an aluminum oxide layer.

12. The glass article (200) according to claim 11, wherein the first super-hard high-refractive-index material layer is the silicon nitride layer, and the second low-refractive-index material layer is the silicon dioxide layer.

13. The glass article (200) according to any one of claims 1 to 12, wherein an anti-fingerprint layer (30) is further disposed on one side that is of the super-hard film (20) and that is away from the glass substrate (10); and an ink layer (40) is further disposed on one side that is of the brightness enhancement film (50) and that is away from the glass substrate (10).

14. The glass article (200) according to claim 13, wherein the glass article (200) further comprises a support film (60), and the support film (60) is located between the brightness enhancement film (50) and the ink layer (40), or between the glass substrate (10) and the brightness enhancement film (50).

15. The glass article (200) according to any one of claims 1 to 14, wherein based on a four-point bending test method, compared with a measured bending strength of the glass substrate (10), a percentage reduction in a measured bending strength of the glass article (200) is less than 20%.

16. The glass article (200) according to any one of claims 2 to 14, wherein based on a four-point bending test method, compared with a measured bending strength of the glass substrate (10), a percentage reduction in a measured bending strength of the glass article (200) is less than 15%.

17. The glass article (200) according to claim 16, wherein the bending strength of the glass article (200) is at least 510 MPa.

18. The glass article according to any one of claims 1 to 17, wherein a simulated prototype formed by combining the glass article with a 200 g counterweight is placed in a vibration abrasion tester filled with abrasive particles, at least half of the simulated prototype is kept buried in the abrasive particles, an abrasion resistance test is performed for at least 120 min at a vibration frequency of 5050±0.5 Hz, and a surface of the glass article exhibits no obvious abrasion and impact damage.

19. The glass article according to any one of claims 1 to 18, wherein a thickness of the glass article is 0.05-0.2 mm, and a bending radius of the glass article is less than or equal to 5 mm.

20. The glass article according to claim 19, wherein the glass article does not fracture when a bending load applied to the glass article is greater than or equal to 300 N based on the four-point bending test method.

21. An electronic device (300), comprising a housing (31) assembled on an outer side of the electronic device (300), and a circuit board (310) located inside the housing (31), wherein the housing (31) comprises the glass article (200) according to any one of claims 1 to 20.

22. The electronic device (300) according to claim 21, wherein the housing (31) comprises a rear cover (311) assembled on a rear side of the electronic device (300), and the rear cover (311) uses the glass article (200).

23. The electronic device (300) according to claim 22, wherein the electronic device (300) further comprises a camera component (33) located inside the housing (31), the housing (31) comprises a camera protective cover plate (312), the camera protective cover plate (312) is disposed over the camera component (33), and the camera protective cover plate (312) uses the glass article (200).
